# EUROPEAN PATENT SPECIFICATION

(11) **EP 1 111 969 B1**
(45) Date of publication and mention of the grant of the patent: **06.02.2008**
(21) Application number: 00126690.7
(22) Date of filing: 05.12.2000
(51) Int. Cl.: H05K 1/02, H05K 1/11

(54) **Method and structure for reducing power noise**
Verfahren und Struktur zur Reduzierung des Leistungsrauschens
Procédé et structure pour réduire le bruit de puissance

(30) Priority: 21.12.1999 EP 99125462
(43) Date of publication of application: 27.06.2001
(73) Proprietor: International Business Machines Corporation, Armonk, NY 10504 (US)
(72) Inventor: Frech, Roland, Dr., 73760 Ostfildern (DE); Klink, Erich, 71101 Schönaich (DE); Rehm, Simone, 71039 Ehningen (DE); Virag, Helmut, 75365 Calw (DE); Winkel, Thomas-Michael, Dr., 71101 Schönaich (DE); Chamberlin, Bruce, Kirkwood, NY 13795 (US); Becker, Wiren Dale, Hyde Park, NY 12538 (US); Ma, Wai Mon, Poughkeepsie, NY 12603 (US)
(74) Representative: Duscher, Reinhard

(56) References cited:
- EP-A- 0 617 568
- DE-A- 19 642 929
- US-A- 5 493 259
- US-A- 5 731 960
- "Low inductance attachment method for decoupling a capacitor for a TCP component" IBM TECHNICAL DISCLOSURE BULLETIN., vol. 38, no. 9, September 1995 (1995-09), pages 235-236, XP000540249 IBM CORP. NEW YORK., US ISSN: 0018-8689

## Description

### Field of the Invention

The present invention relates in general to the reduction of power noise. In particular, it relates to such a reduction in the mid- and high-frequency range. Still more specifically, the invention relates to a pad-via configuration for SMT decoupling capacitors.

### Background of the Invention

Due to the growing complexity of semiconductor devices the total amount of switching current needed by the logic devices increases. As a result the simultaneous switching noise increases also and results in a slower working logic, in a slower cycle time and thus in a decreasing system performance. In order to yield a higher system performance one goal of modern system designs is to stabilize the voltage. It is known that a stabilized voltage can be obtained with the help of decoupling capacitors mounted on MCMs, cards and boards. However, the higher power noise combined with a lower operating voltage of the semiconductor devices results in a growing number of capacitors needed for decoupling purposes. This results in additional problems:
- large areas on MCM, cards and/or boards needed for capacitor placement and with a growing distance of the capacitor to the noise source the effectiveness of the capacitor is decreased
- reduced placement area for capacitors, due to a higher component integration factor on cards/boards
- growing costs for assembled components, due to a higher number of components and increase of manufacturing time (drilling of via holes, component placement, edging, etc.)
- wiring problems on cards/boards, due to an increased number of power/ground vias as well as a possibly increased signal delay, decreased cycle time, increased number of card/board layers and decreased system performance
- decreased effective copper on power and ground layers, due to an increased number of via and clearence holes; increased DC resistance of power and ground planes; increased DC voltage drop on card/board between voltage source and logic; decreased system performance.

In order to make all the capacitors as effective as possible the charge of the capacitors must be provided as fast as possible to the noise source. Therefore the internal inductance of the capacitor as well as the path inductance (capacitor to noise source) must be kept as small as possible. Due to these restrictions the capacitor must
- be placed as close as possible to the noise source;
- have a small internal inductance; and
- have a small inductance of the capacitor pad and the via connecting the pad to the voltage and ground plane.

### Description of the Prior Art

Decoupling capacitors are used to provide a short term current source or sink for the circuitry in an effort to provide a stable power supply. For example, the decoupling capacitors act as a storage device for electrical charge which can provide a short term current source for the circuitry.

It is well known in the art that capacitors with a low capacitance value may be used as a high frequency noise filter, and capacitors with a high capacity value may be used as a low frequency noise filter.

Typically, decoupling capacitors are placed as close as possible to the circuitry so as to increase their effectiveness. Thus, US-A-4,654,694 discloses side connections to place a capacitor in close proximity to a chip or, alternatively, to a chip and GND/Power I/O. By this technique, the effective inductance of the power paths is minimized.

In some instances, decoupling capacitors have been placed within the package containing the integrated circuit. Thus, US-A-4,945,399 describes a semiconductor chip carrier including a plurality of distributed high frequency decoupling capacitors as an integral part of the carrier. The distributed capacitors are formed as a part of the first and second layers of metallurgy and separated by a layer of thin film dielectric material.

US-A-5,132,613 discloses an integrated circuit test structure including individual layers of a personalization substrate and decoupling capacitors, whereby said decoupling capacitors are electrically coupled to the metal lines in close proximity, the personalization substrate thereby minimizing the associated lead inductance and thus maximizing the effectiveness of the decoupling capacitors.

Although there are some advantages in using capacitors with a low internal inductance, a great disadvantage is the also low capacitance of the capacitor itself (low inductance is only available with low capacitance). One further disadvantage is the decreased effectiveness of the low inductive capacitor that is limited by the inductance of the mounting pads together with the vias of the capacitor.

US-A-5,731,960 describes a noise-suppression apparatus for a PCB comprising a decoupling capacitor coupled to mounting regions of pads also having a boundary region connected to vias.

### Summary of the Invention

It is therefore an object of the present invention to provide a method for minimizing switching noise in the high- and mid-frequency range on printed circuit cards or boards by means of several surface mount decoupling capacitors, whereby the parasitic inductance of the pads and vias is minimized.

It is a further object of the present invention to increase the effectiveness of the decoupling capacitors, to reduce the voltage drop and to increase the overall system performance.

These and other objects and advantages are achieved by a method for minimizing switching noise in the high- and mid-frequency range according to claim 1 and by the structure of claim 4.

Advantageous embodiments of the method according to the invention are laid down in the dependent claims.

### Brief Description of the Drawings

- Fig. 1: shows the common pad and via design according to the state of the art;
- Fig. 2: depicts the design according to Fig. 1 in a three-dimensional view;
- Fig. 3: is a two-dimensional view of multiple capacitor pads with vias and mounted capacitors according to the state of the art;
- Fig. 4: shows the arrangement of Fig. 3 in a three-dimensional view;
- Fig. 5: is a two-dimensional view of the capacitor pad and via configuration according to the invention;
- Fig. 6: depicts the configuration of Fig. 5 in a three-dimensional view;
- Figs.7 and 8: show another configuration according to the invention, providing multiple decoupling capacitors;
- Figs. 9 and 10: show still another configuration according to the invention;
- Figs. 11 and 12: show yet another configuration according to invention; and
- Fig. 13: is a graph showing a comparison of the simulated loop inductance for a group of three capacitors using state of the art configuration and the configuration according to the invention.

### Description of the Preferred Embodiment

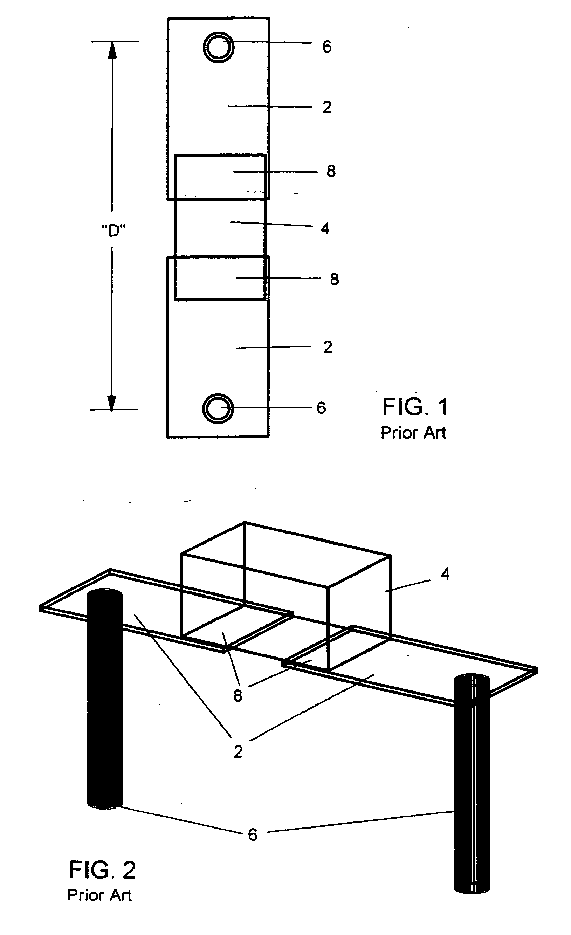

In Figure 1 the common pad and via design (as normally recommended by the capacitor vendor) is shown as a top view drawing in combination with one mounted capacitor. Figure 2 shows the same pad and via configuration with the mounted capacitor in a three-dimensional view. The size of the pad 2 itself is mainly driven by the size of the capacitor body 4 and by manufacturing especially soldering recommendations. As recommended the vias 6 are placed outside the soldering area 8 of the pad. As shown in figure 1 and 2 the center to center distance "D" of the vias is large. Each pad 2 of the capacitor 4 is connected with a via 6 to power and ground respectively (not shown).

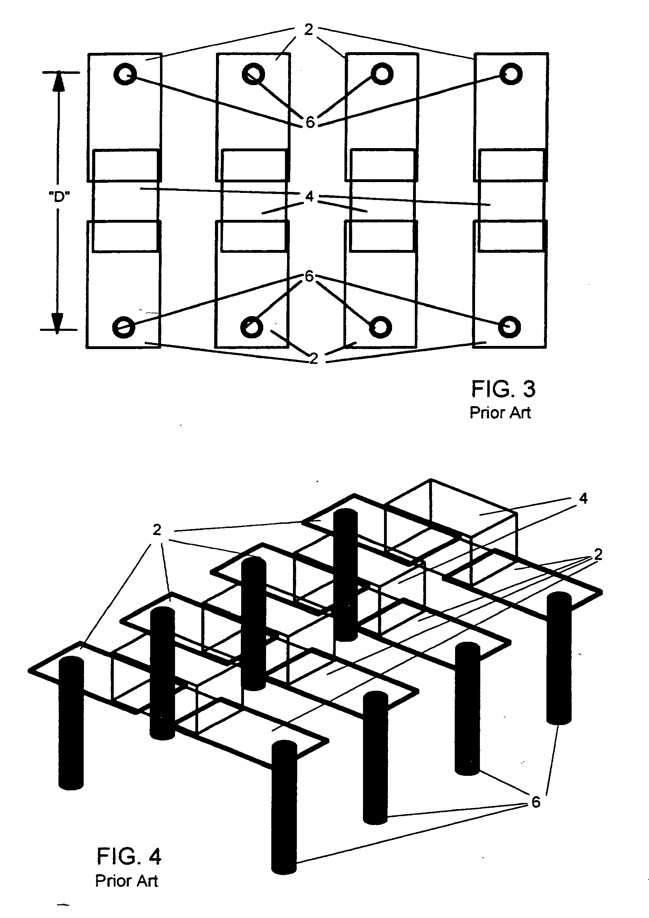

In order to be able to use multiple surface mount capacitors the capacitors are mounted side by side on pads with a safety distance which is specified by automatic placement restrictions. Figure 3 shows a two-dimensional and figure 4 a three-dimensional drawing of multiple capacitor pads 2 with vias 6 and mounted capacitors 4.

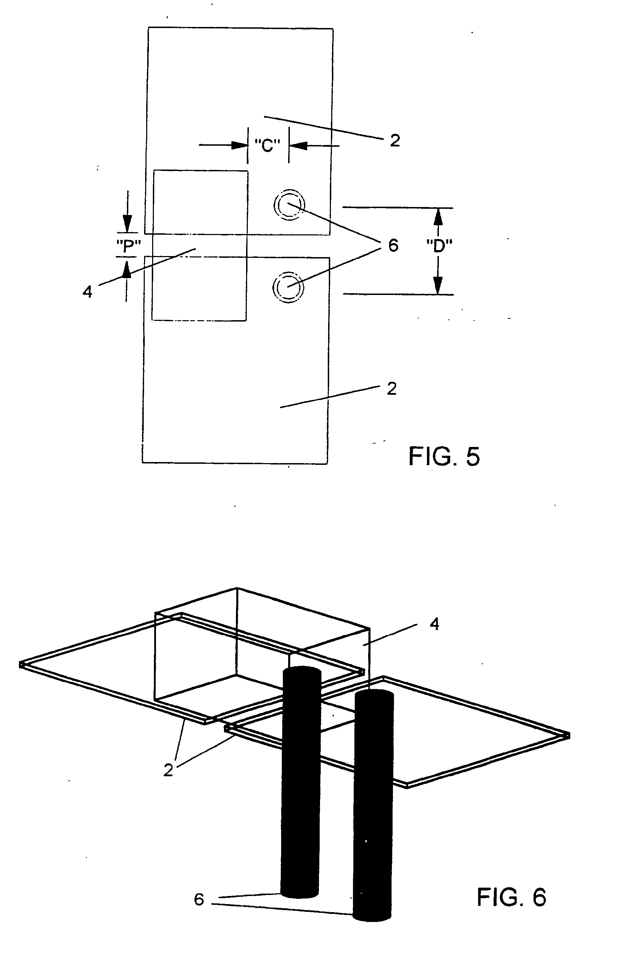

The new capacitor pad and via configuration according to the invention is shown in figures 5 and 6, respectively. The main differences between the old pad via configuration as shown in figures 1 and 2 are the pad size, the distance between both pads and the via location and thus also the center to center distance "D" of the vias 6. As compared to the state of the art, the pads are now enlarged in, the vias thereby being arranged in close proximity to the respective capacitors. In order to minimize the loop inductance of the pads and vias the pad via configuration has to meet the following requirements:
- minimum center to center distance "D" of the vias 6
   The reason is that the smaller the distance the higher the mutual coupling between the vias and the lower the loop inductance
- minimum distance P" between both capacitor pads 2
   The reason is that the smaller the distance between the pads the smaller the distance of the vias
- minmum distance "C" between the center of vias 6 and the contact point between the capacitor 4 and the pad 2
   The reason is that the smaller the distance the smaller the loop inductance.

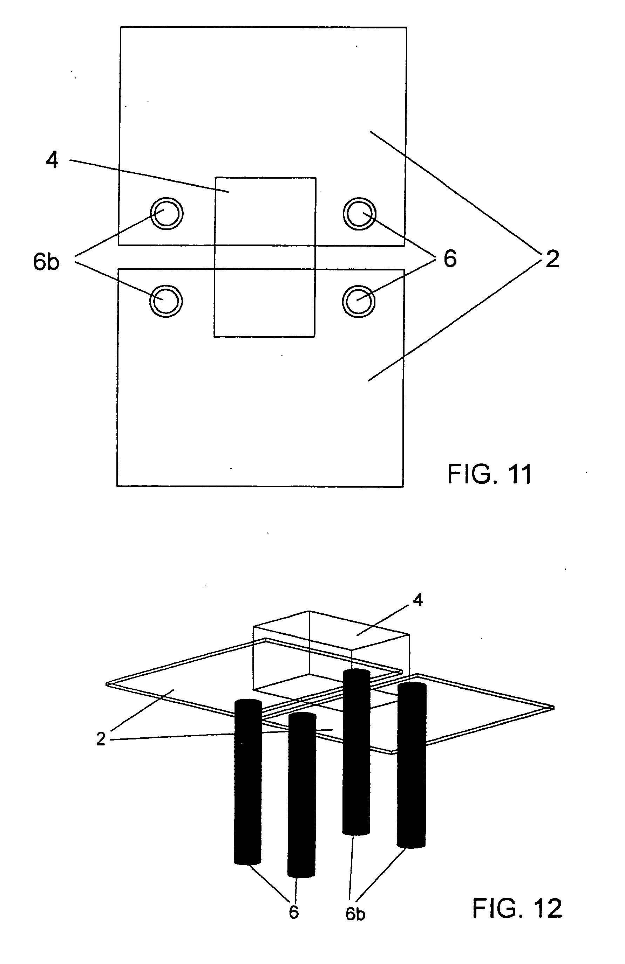

A further reduction of the loop inductance of the pad via configuration as shown in Figures 5 and 6 can be achieved by:
1. enlarging the width of the pad 2 and adding a second via pair on the left side of the capacitor (cf. Figs. 11 and 12), so that a structure results wherein vias and capacitors are arranged alternatingly;
   Thus, by paralleling the vias, the inductance L is decreased.
2. using multiple vias on one pad in a row;
   Here, paralleling the vias leads to a decrease in required floor space compared to 1.
3. using a larger via diameter;
4. using a larger pad size;
   Points 3 and 4 result in a decreased inductance L.
5. placing the vias under the capacitor body;

This, as well as point 2, results in a decrease in rquired floor space and the minimum space leads to a minimum inductance.

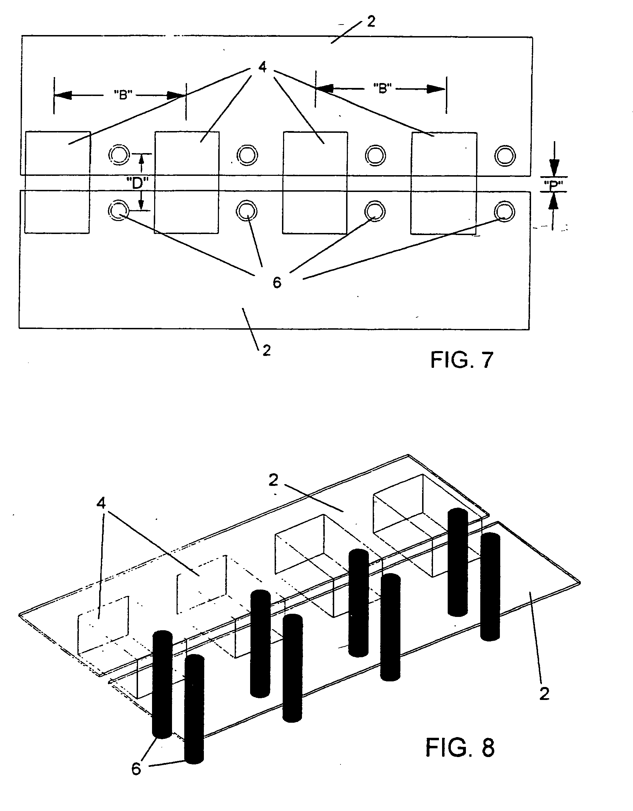

In order to use multiple surface mount capacitors for decoupling purposes of one voltage the capacitors can be mounted on capacitor pad lines as shown in Figures 7 and 8. The distances "B" between the capacitor bodies remain the same as in Figs. 3 and 4, being determined mainly by the assembly tool used. The vias 6 are placed in the area between the capacitors 4 with a minimum center to center distance "D" of a via pair. The distance "P" between the pad lines is also reduced to a minimum.

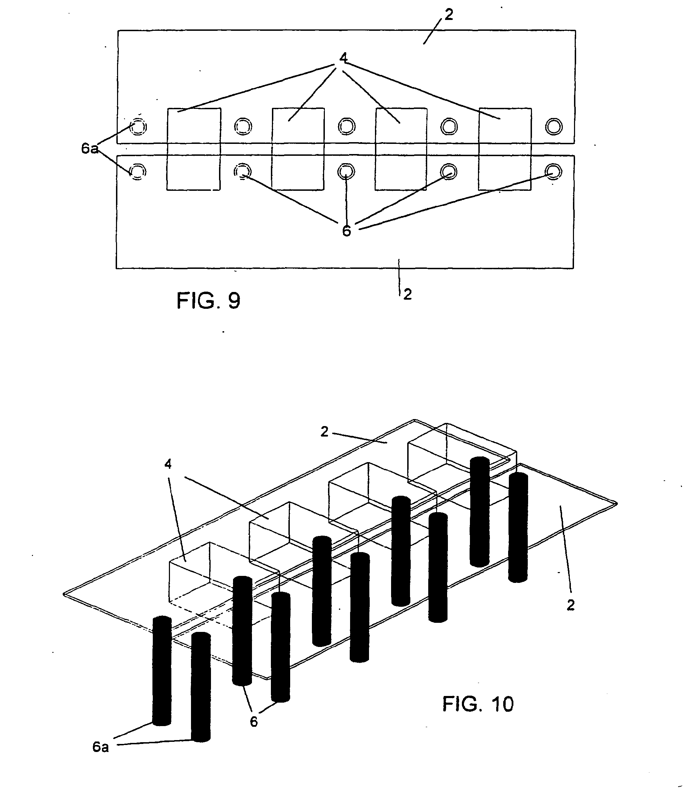

A further improvement of this structure is shown in Figures 9 and 10 where the width of the pad 2 line is enlarged and an additional via pair 6a is added at the outer ends of the pad line 2. In order to avoid shorts between the pads caused by capacitors which are placed incorrectly, the pad line distance under the capacitor can be enlarged.

A further improvement can be achieved if the pads 2 of figure 5 are enlarged so that an additional via pair 6b can be placed on the outer side of capacitor 4. This embodiment is shown in figs. 11 and 12.

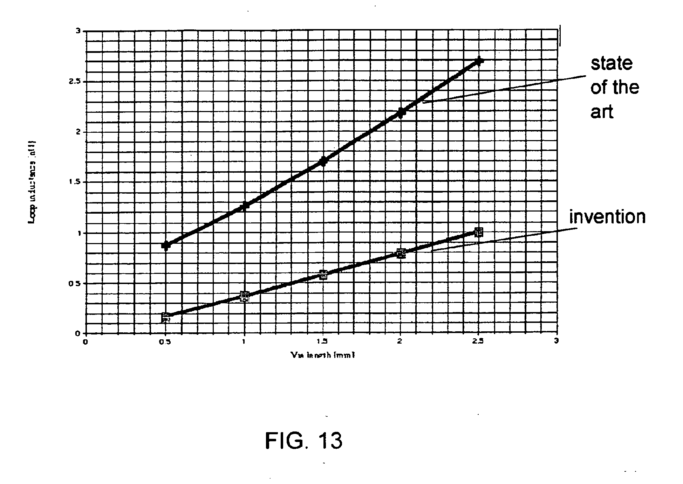

Figure 13 shows a comparision of the simulated loop inductance for a group of three capacitors using seperate pads (old design) and the pad line structure (new design) with 18mils via diameter and for different via lengths. Depending of the via length the total loop inductance can by reduced by a factor of 5.3 for a via with a length of 500µm and by a factor of 2.7 for via with a length of 2.5mm.

Due to the reduction of the pad-via loop inductance the effectiveness of the capacitor is increased and the total number of capacitors needed for decoupling purposes on cards and boards can be reduced. In table 1 a comparision of the numbers of capacitors, needed for decoupling of the 1.5V and of the 1.8V on a board, is shown as an example. The calculations were performed using the old pad via design and the new pad via design. The number of capacitors used for 1.5V and 1.8V decoupling can be reduced from 4792 to 1985 and from 373 to 155.

**Table 1**

| | Old Design | New Design |
|---|---|---|
| Capacitor # on 1.5V | 4792 | 1985 |
| Capacitor # on 1.8V | 373 | 155 |
| Capacitor # total | 5165 | 2140 |

The advantages of these reductions are:
- decreasing prices for assembled components due to decreasing component number
- reduce manufacturing cost due to reduced production cycle time (reduced component placement time and reduced drilling time for vias)
- reduce wireability problems due to reduced capacitor number and via number
- reduce component placement problems on dense assembled cards and boards
- reduce component distances due to lower number of capacitors
- reduce signal delay, reduce cycle time, increase system performance
- improve card/board cross section due to lower via number
- reduce parallel resonances between different types of capacitors due to lower parasitic inductance of the vias

Another main advantage of the new pad via design is the improved wireability in the capacitor area. Each via is fabricated with clearence holes on each power layer (for a via connected to ground) and on each ground layer (for a via connected to power). Due to different reasons (e.g. coupling, impedance mismatch) signal wires are in general not allowed to cross a clearence hole. Thus the clearence hole reduces the wireability in the capacitor area. In contrast to the old capacitor pad-via design were the clearence holes of a via pair (power and ground via of one capacitor) are seperated, the via holes of the new capacitor pad-via design are overlapping due to the small distance between the via pair. Due to the overlap of the via holes the wiring area is increased. Thus the wireability in the capacitor area is increased, the number of wire layers can be reduced in a dense wiring area and at last the card and board costs can be reduced.

## Claims

1. Method for minimizing switching noise in the high- and mid-frequency range on printed circuit cards or boards by means of a plurality of surface mounted decoupling capacitors (4), said capacitors each comprising a pair of opposing pads (2), each of said pads being connected to power/ground planes by respective vias (6),
**characterized by** the steps of
arranging said pairs of capacitor pads by connecting pads to form enlarged padlines (2) and at the same time minimizing the distance (P) between opposite pads, and arranging said respective vias (6) at the smallest possible center to center distance (D) with respect to each other and, with respect to respective decoupling capacitors, at the smallest distance (C) between the via (6) center and the contact point between the respective decoupling capacitor (4) and the pad (2).

2. Method according to claim 1, wherein said respective vias are arranged at only one side of the decoupling capacitor power/ground planes.

3. Method according to claim 1, wherein said respective vias are arranged on both sides of the decoupling capacitor power/ground planes.

4. A structure including
- a printed circuit card or board,
- a plurality of decoupling capacitors (4) mounted on the surface of said card or board, each of said capacitors consisting of a pair of opposing pads (2), said pads being connected to power/ground planes by respective vias (6)
**characterized in that**
said pairs of capacitor pads are arranged to form enlarged padlines (2), and at the same time are arranged at the smallest distance (P) between opposite pads, and that said respective vias (6) are arranged at the smallest possible center to center distance (D) with respect to each other and, with respect to respective decoupling capacitors, at the smallest distance (C) between the via (6) center and the contact point between the respective decoupling capacitor (4) and the pad (2).

5. Structure according to claim 4 wherein said respective vias are arranged at only one side of the decoupling capacitor power/ground planes.

6. Structure according to claim 4 wherein said respective vias are arranged on both sides of the decoupling capacitor power/ground planes.

## Patentansprüche

1. Verfahren zur Minimierung des Schaltungsrauschens im Hoch-und Mittelfrequenzbereich auf Leiterkarten oder -platten mittels mehrerer oberflächenmontierter Entkopplungskondensatoren (4), wobei jeder der Kondensatoren ein Paar gegenüberliegender Pads (2) aufweist und wobei jedes der Pads jeweils über Durchkontaktierungen (6) mit Strom-/Masseflächen verbunden ist,
**gekennzeichnet durch** folgende Schritte:
Anordnen des Paares von Kondensatorpads **durch** Verbinden der Pads zu Padstreifen (2) mit vergrößerter Fläche und gleichzeitig Minimieren des Abstands (P) zwischen gegenüberliegenden Pads sowie Anordnen der jeweiligen Durchkontaktierungen (6) zueinander im kleinstmöglichen Abstand (D) von Mittelpunkt zu Mittelpunkt sowie zu den jeweiligen Entkopplungskondensatoren im kleinstmöglichen Abstand (C) zwischen dem Mittelpunkt der Durchkontaktierung (6) und dem Kontaktpunkt zwischen dem jeweiligen Entkopplungskondensator (4) und dem Pad (2).

2. Verfahren nach Anspruch 1, bei dem die jeweiligen Durchkontaktierungen nur auf einer Seite der Strom-/Masseflächen des Entkopplungskondensators angeordnet sind.

3. Verfahren nach Anspruch 1, bei dem die jeweiligen Durchkontaktierungen auf beiden Seiten der Strom-/Masseflächen des Entkopplungskondensators angeordnet sind.

4. Struktur, die Folgendes umfasst:
- eine Leiterkarte oder -platte,
- mehrere auf der Oberfläche der Leiterkarte oder -platte montierte Entkopplungskondensatoren (4), wobei jeder der Kondensatoren ein Paar gegenüberliegender Pads (2) umfasst und wobei die Pads über entsprechende Durchkontaktierungen (6) mit Strom-/Masseflächen verbunden sind,
**dadurch gekennzeichnet, dass**
das Paar Kondensatorpads so angeordnet ist, dass die Pads vergrößerte Padstreifen (2) bilden und gleichzeitig im kleinsten Abstand (P) zwischen gegenüberliegenden Pads angeordnet sind und die jeweiligen Durchkontaktierungen (6) zueinander im kleinstmöglichen Abstand (D) von Mittelpunkt zu Mittelpunkt sowie zu den jeweiligen Entkopplungskondensatoren im kleinstmöglichen Abstand (C) zwischen dem Mittelpunkt der Durchkontaktierung (6) und dem Kontaktpunkt zwischen dem jeweiligen Entkopplungskondensator (4) und dem Pad (2) angeordnet sind.

5. Struktur nach Anspruch 4, bei der die jeweiligen Durchkontaktierungen nur auf einer Seite der Strom-/Masseflächen des Entkopplungskondensators angeordnet sind.

6. Struktur nach Anspruch 4, bei der die jeweiligen Durchkontaktierungen auf beiden Seiten der Strom-/Masseflächen des Entkopplungskondensators angeordnet sind.

## Revendications

1. Procédé destiné à minimiser un bruit de commutation dans la gamme des hautes fréquences et des fréquences moyennes sur des cartes ou des plaquettes à circuits imprimés au moyen d'une pluralité de condensateurs de découplage montés en surface (4), lesdits condensateurs comprenant chacun une paire de plages de connexion opposées (2), chacune desdites plages de connexion étant connectée à des plans d'alimentation/de masse par des traversées respectives (6),
**caractérisé par** les étapes consistant à
agencer lesdites paires de plages de connexion de condensateur en connectant les plages de connexion pour former des lignes de plages de connexion agrandies (2) et en minimisant en même temps la distance (P) entre les plages de connexion opposées, et agencer lesdites traversées respectives (6) à la distance de centre à centre (D) la plus petite possible les unes par rapport aux autres, et par rapport aux condensateurs de découplage respectifs, à la plus petite distance (C) entre le centre de la traversée (6) et le point de contact entre le condensateur de découplage respectif (4) et la plage de connexion (2).

2. Procédé selon la revendication 1, dans lequel lesdites traversées respectives ne sont agencées que d'un côté des plans d'alimentation/de masse du condensateur de découplage.

3. Procédé selon la revendication 1, dans lequel lesdites traversées respectives sont agencées des deux côtés des plans d'alimentation/de masse du condensateur de découplage.

4. Structure comprenant
- une carte ou une plaquette à circuit imprimé,
- une pluralité de condensateurs de découplage (4) montés sur la surface de ladite carte ou plaquette, chacun desdits condensateurs consistant en une paire de plages de connexion opposées (2), lesdites plages de connexion étant connectées aux plans d'alimentation/de masse par des traversées respectives (6),
**caractérisée en ce que**
lesdites paires de plages de connexion de condensateur sont agencées pour former des lignes de plages de connexion agrandies (2), et sont en même temps agencées à la plus petite distance (P) entre les plages de connexion opposées, et **en ce que** lesdites traversées respectives (6) sont agencées à la distance de centre à centre (D) la plus petite possible les unes par rapport aux autres, et par rapport aux condensateurs de découplage respectifs, à la plus petite distance (C) entre le centre de la traversée (6) et le point de contact entre le condensateur de découplage respectif (4) et la plage de connexion (2).

5. Structure selon la revendication 4, dans laquelle lesdites traversées respectives ne sont agencées que d'un côté des plans d'alimentation/de masse du condensateur de découplage.

6. Structure selon la revendication 4, dans laquelle lesdites traversées respectives sont agencées des deux côtés des plans d'alimentation/de masse du condensateur de découplage.
